(19) Europäisches Patentamt
European Patent Office
Office européen des brevets

(11) **EP 1 568 135 B1**

(12) **EUROPEAN PATENT SPECIFICATION**

(45) Date of publication and mention
of the grant of the patent:
**14.04.2010 Bulletin 2010/15**

(51) Int Cl.:
**H03K 19/0175** (2006.01)     **H03K 19/003** (2006.01)

(21) Application number: **03769849.5**

(86) International application number:
**PCT/IB2003/005198**

(22) Date of filing: **17.11.2003**

(87) International publication number:
**WO 2004/047296 (03.06.2004 Gazette 2004/23)**

(54) **INTEGRATED FLOATING POWER TRANSFER DEVICE WITH ELECTROMAGNETIC EMISSION CONTROL CIRCUIT AND METHOD**

INTEGRIERTE SCHWEBENDE LEISTUNGSÜBERTRAGUNGSVORRICHTUNG MIT REDUZIERTEN ELEKROMAGNETISCHEN EMISSIONEN

DISPOSITIF DE TRANSFERT DE PUISSANCE FLOTTANT INTEGRE COMPRENANT UN CIRCUIT DE COMMANDE D'UNE EMISSION ELECTROMAGNETIQUE ET PROCEDE ASSOCIE

(84) Designated Contracting States:
**AT BE BG CH CY CZ DE DK EE ES FI FR GB GR HU IE IT LI LU MC NL PT RO SE SI SK TR**

(30) Priority: **18.11.2002 US 427413 P**

(43) Date of publication of application:
**31.08.2005 Bulletin 2005/35**

(73) Proprietor: **NXP B.V.**
**5656 AG Eindhoven (NL)**

(72) Inventors:
• **DONALDSON, William**
**San Jose, CA 95131 (US)**
• **TOY, Edmond**
**San Jose, CA 95131 (US)**

(74) Representative: **Schouten, Marcus Maria et al**
**NXP B.V.**
**IP & L Department**
**High Tech Campus 32**
**5656 AE Eindhoven (NL)**

(56) References cited:
**US-A- 4 945 267     US-A- 6 052 019**
**US-A- 6 154 061**

## Description

The present invention relates in general to power transfer devices, and more particularly, to a switch control circuit and method for constraining electromagnetic emissions from an integrated floating power transfer device.

Many system designs include power conversion circuitry to develop a required operating voltage. One such power conversion circuit is known as a charge pump. A charge pump is a device for creating increases in supply voltage or for inverting a supply voltage to generate a split supply. Many of these devices are related to applications using non-volatile memory circuits, which require a high voltage for programming. In a conventional charge pump power conversion circuit, the load device connects so that one terminal thereof is common to one of the supply terminals, typically the ground reference.

US. 4, 807, 104 discloses a power conversion circuit which is both a voltage multiplying and inverting charge pump. However, the output of the power conversion circuit remains referenced to the ground node.

In certain system implementations, it may be advantageous to power the system using a floating power transfer device. By floating the power transfer device, if a terminal in the system were to short, then the system may still be able to continue to operate. For example, in an automobile bus network, the signaling portion of the system on the bus could be floating relative to any other reference, such as ground or battery positive. This would provide enhanced fault tolerance by allowing communications to still occur notwithstanding a short at a terminal thereof.

US 6,154,061 describes a can bus driver with symmetrical differential output signals having a first and second switch control circuit, which are connected to a high and a low side bus node of a floating bus, respectively, wherein the first and second switch control circuits are realized as complementary circuits. Moreover, there are driver transistors, which are controlled by two floating control voltages, which are connected to an interconnection node. The difference between the current through the driver transistors is compensated by a change in the voltage level in the interconnection node. Thereby the output is kept equal and highly symmetrically.

Therefore it is an object to provide a device and a method for operating a bus, having an enhanced fault tolerance.

The object is solved by the features of the independent claims.

The shortcomings of the prior art are overcome and additional advantages are provided by the provision of a floating power transfer device, which includes a floating bus, and a power and data system for driving the floating bus. The power and data system include a charge pump circuit. Electromagnetic emission control is provided by limiting the current to a fixed value with a rising voltage on the floating bus. Thus, at least one switch control circuit is coupled between the floating bus and the power and data system for facilitating charging of the floating bus and controlling electromagnetic emissions from the floating bus by constraining a slew rate on the floating bus.

In another aspect, a circuit is provided which includes a first switch control circuit for electrically coupling to a high side bus node of a floating bus, and a second switch control circuit for electrically coupling to a low side bus node of the floating bus, wherein the first switch control circuit and the second switch control circuit comprise complementary control circuits for controlling charging of the floating bus by a power and data system. A reference circuit is also provided for generating a first reference signal for the first switch control circuit and a second reference signal for the second switch control circuit. The first reference signal and the second reference signal are employed by the first switch control circuit and the second switch control circuit, respectively, for controlling electromagnetic emissions from the floating bus by constraining a slew rate on the floating bus.

In a further aspect, a method for constraining electromagnetic emissions from an integrated floating power transfer device is provided. This method includes: tailoring a transfer characteristic of a first switch control circuit to be electrically coupled to a high side bus node of a floating bus, and tailoring a transfer characteristic of a second switch control circuit to be electrically coupled to a low side bus node of the floating bus, wherein the first switch control circuit and the second switch control circuit comprise complementary control circuits for controlling charging of the floating bus by a power and data system; and generating, when in use, a first reference signal for the first switch control circuit and a second reference signal for the second switch control circuit, wherein the first reference signal and the second reference signal are employed by the first switch control circuit and the second switch control circuit, respectively, for controlling electromagnetic emissions from the floating bus by constraining a slew rate on the floating bus.

Additional features and advantages are realized through the techniques of the present invention. Other embodiments and aspects of the invention are described in detail herein and are considered a part of the claimed invention.

The subject matter which is regarded as the invention is particularly pointed out and distinctly claimed in the claims at the conclusion of the specification. The foregoing and other objects, features, and advantages of the invention are apparent from the following detailed description taken in conjunction with the accompanying drawings in which:

FIG. 1 is a schematic of one embodiment of a conventional voltage-doubling charge pump circuit;
FIG. 2 is a schematic of one embodiment of a floating power transfer device which enables the dual function of power and data transfer;

FIG. 3 is a schematic of one embodiment of an integrated circuit implementation of a floating power transfer device;

FIG. 4 is a schematic of one embodiment of an integrated floating power transfer device having switch control circuits for limiting electromagnetic emissions, in accordance with an aspect of the present invention;

FIG. 5 is a graph of a transfer characteristic for a switch control circuit for the integrated floating power transfer device of FIG. 4, in accordance with an aspect of the present invention;

FIG. 6 is a schematic of one embodiment of a switch control circuit for the integrated floating power transfer device of FIG. 4, in accordance with an aspect of the present invention;

FIG. 7 is a schematic of one embodiment of a N type transistor level implementation of the switch control circuit of FIG. 6, in accordance with an aspect of the present invention;

FIG. 8 is a schematic of an enhanced N type transistor level implementation of the switch control circuit of FIG. 6, in accordance with an aspect of the present invention;

FIG. 9 is a schematic of another enhanced N type transistor level implementation of the switch control circuit of FIG. 6, in accordance with an aspect of the present invention; and

FIG. 10 is a schematic of one embodiment of a P type transistor level implementation of a switch control circuit such as shown in FIG. 7, in accordance with an aspect of the present invention.

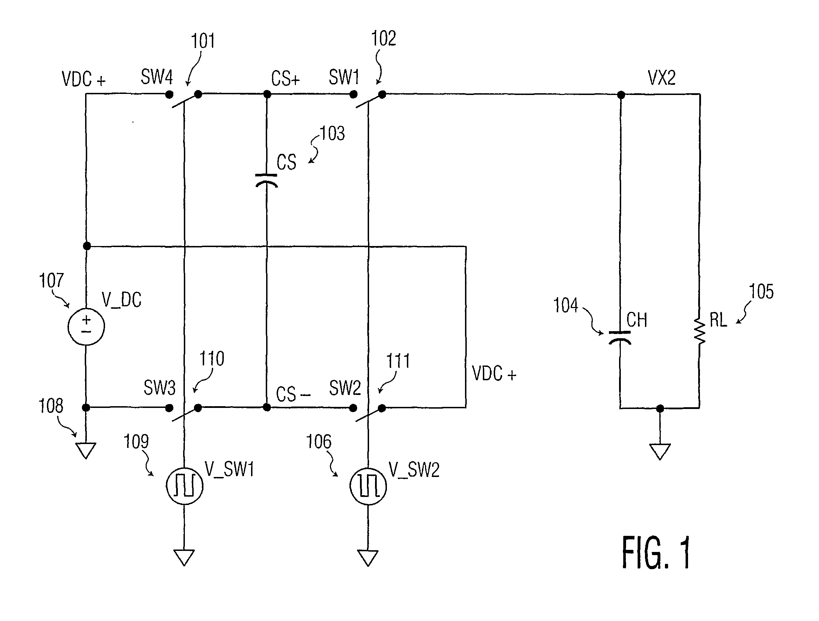

Reference is now made to the drawings, wherein the same reference numbers used throughout different figures designate the same or similar components. One embodiment of a power transfer device for powering a load 105 is shown in FIG. 1. This charge transfer device delivers charge onto a capacitor CS 103 through switches SW4, SW3 101, 110 under control of a signal generator 109. Charge is provided by a power supply voltage (V_DC) 107, one side of which is referenced to ground 108. A capacitor CH 104 provides the modified power supply for load 105. In this voltage doubling example, capacitor 104 is charged with double the voltage of capacitor CS when switches SW1, SW2 102, 111 are closed by signal generator 106.

The power transfer device of FIG. 1 is referred to as a ground referenced charge transfer device since the device supplies power to the load via a ground referenced capacitance. Circuits such as depicted in FIG. 1 are often used in applications such as $E^2ROM$ programming or extending the operating range of diverse analog circuits. As explained further below, the present invention does not necessarily seek to increase or invert an output voltage, but rather employs a similar switching scheme to precharge a floating bus with a voltage that is close to the original source-voltage. A circuit implemented in accordance with an aspect to the present invention is designed to allow power to be drawn continuously from the floating circuit, while a signaling scheme may partially or completely discharge the floating bus. The combined power and data feature of this apparatus has been previously described in commonly assigned European patent document EP 1 065 600 A2, the entirety of which is hereby incorporated herein by reference.

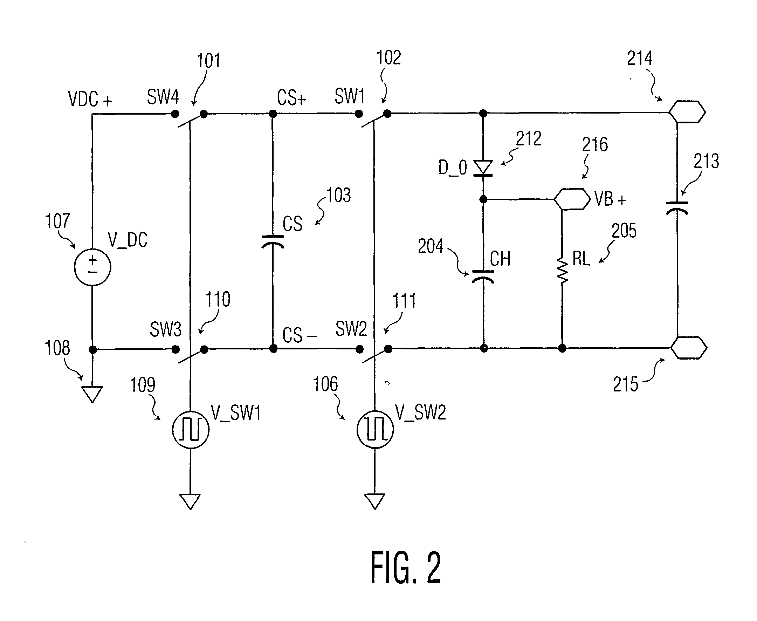

One embodiment of a floating power transfer device that enables the dual function of power and data transfer is shown in FIG. 2. A floating bus is a bus that is electrically isolated from the ground reference 108 of the source voltage V_DC 107. In the circuit depicted in FIG. 2, the output VB+ 216 provides a continuous power source relative to the floating bus, which is defined as the two nodes BUS+ 214 and BUS- 215. During the "data" phase when signal generator V_SW1 109 is at a logical 1, the source switches SW3, SW4 110, 101 are "on" and the source voltage is driven onto the shuttle capacitor CS 103. The output switches SW1, SW2 102, 111 are "off" and the floating bus BUS+ 214 and BUS- 215 is available for signaling purposes. Power is available from the floating bus due to the energy retained by the hold capacitor CH 204. A diode 212 prevents the bus signal voltages from discharging the hold capacitor 204. A "power" phase, when signal generator V_SW2 106 is at a logical 1, completes the two-phase cycle by turning on the bus switches 102, 111, while V_SW1 109 returns a logic zero, turning off the source switches 101, 110. During this period, charge is delivered from the shuttle capacitor 103 to the floating bus 214, 215, and consequently to the hold capacitor 204. The voltage on the floating bus is restored to a value close to the source voltage. Depleted charge from the hold capacitor 204 is restored, while maintaining the continuous source of power from output VB+ 216, as required.

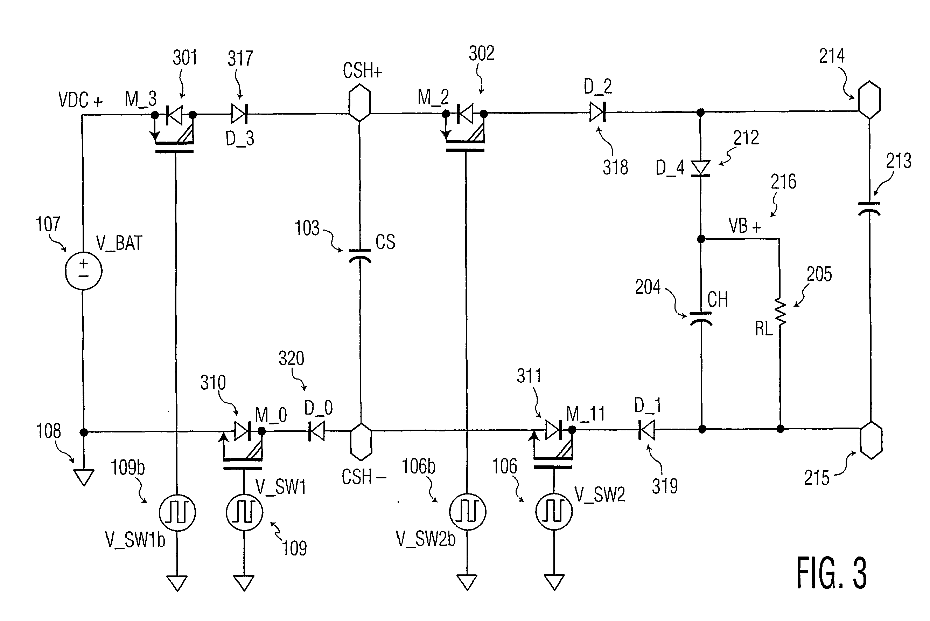

An integrated circuit (IC) implementation of a floating power transfer device with a combined power and data feature is shown in FIG. 3. In this implementation, switches 101, 110 and 102, 111 are replaced by DMOS transistors 301, 310 and 302, 311, which are P type and N type transistors. These devices require the addition of diodes 317, 318, 319, 320 to maintain the isolation of the floating bus BUS+, BUS- 214, 215 from the source voltage 107 and ground 108. This means that there are additional electrical losses in this form of the circuit and the available output voltage relative to the original source voltage is reduced. The signal generators 106, 109, now require additional complementary control sources 109b, 106b to drive the P-type DMOS transistor switches 301, 302 (with the N-type DMOS transistor switches 310, 311 being driven by control sources 109, 106, respectively). Typically, the control sources are driven by digital signals, biased at the prevailing logic-supply voltage, with the same phasing as described above in connection with the floating power transfer device of FIG. 2.

Power is again available in this implementation from the floating circuit due to energy retained by the hold capacitor CH 204. Diode 212 again prevents the bus signal voltages from discharging the hold capacitor 204. Output VB+ 216 at one side of load 205 provides a continuous power source relative to the floating bus.

When a signal appears on the floating bus during the data phase, it may drive the bus voltage to 0 V or some other predetermined intermediate value. For the remainder of this phase, the bus is held at that value. At the commencement of the power-phase, the bus transistor switches 302, 311 turn on and the bus voltage is restored to the power level. In this system, the speed at which the bus voltage changes is dependent on the impedance of the switches 302, 311 and diodes 318, 319 conducting current from the shuttle capacitor CS 103 onto the floating bus. When the rate of change is uncontrolled, as in this case, the edge of the voltage waveform can be quite sharp. This results in a signal spectrum with a high harmonic content. If the spectral content of the signal spreads into adjacent radio bands, then this is called electromagnetic emission (EME). Certain applications of a floating power transfer device such as depicted in FIG. 3 may require the system to limit the EME to a minimum. In one aspect, the present invention provides a technique for reducing/constraining the EME generated by the floating supply circuit.

Disclosed herein is a technique for constraining the EME output from a floating bus driven by a combined power and data system and based on an integrated circuit (IC) charge pump circuit. As noted above, the uncontrolled slope of the power-phase voltage edge can generate EME that interferes with radio reception. Replacing the bus-switch transistors 302, 311 of FIG. 3 with special switch control circuits as disclosed herein improves the EME performance of a target power transfer device. In one example, the transfer device is assumed to have two operating modes, a high-speed mode and a low-speed mode. It is possible to achieve a better EME performance in the low-speed mode by taking advantage of the longer time interval available to deliver charge onto the bus. This means that, in certain implementations, the switch control circuits have a selectable mode of operation that is dependent on the bus speed.

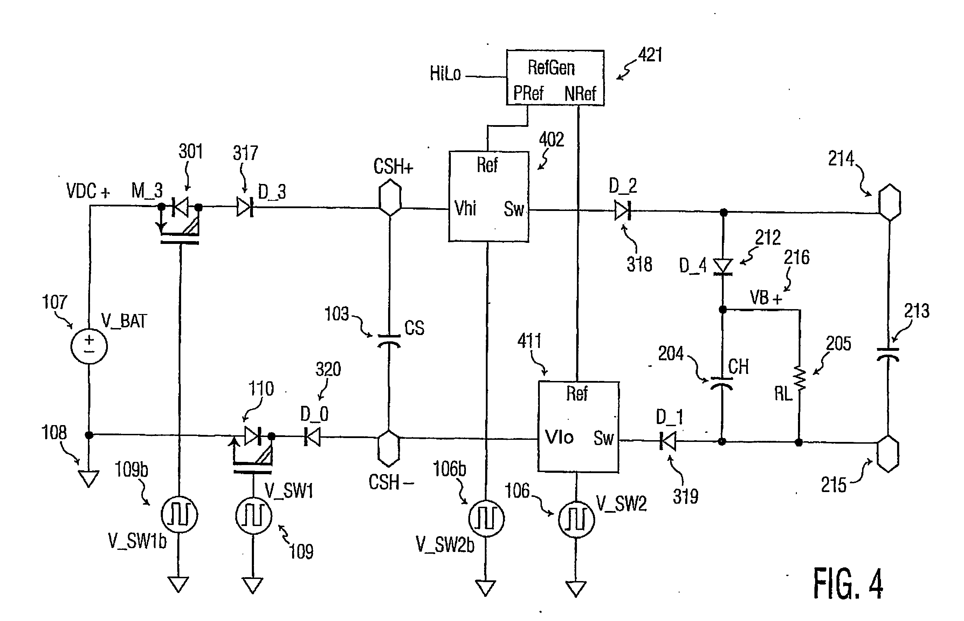

The floating bus forms a balanced system where the high-side BUS+ 214 switch 302 and diode 318 are matched by a corresponding low-side BUS- 215 switch 311 and diode 319, and which includes the implicit bus capacitance CBUS 213. The current flow is out of the BUS+ and into the BUS- terminal. Two complementary circuits are used to maintain the balance of the system, while achieving the reduction in EME that is desired. The circuit shown in FIG. 4 depicts one embodiment of a floating power transfer device with EME control.

In FIG. 4, the source-side switches 301, 310 and diodes 317, 320 remain as described in FIG. 3, while the BUS-side switches are replaced by switch control circuits 402, 411 and a reference circuit 421. Switch control circuit 402, in this example, is P-type transistor based and provides a controlled current output, while switch control circuit 411, in this example, provides an N-type transistor controlled current output. The reference circuit 421 provides two stable, temperature compensated reference signals that are used in setting operation of the switch control circuits 402, 411.

The conceptual operation of the switch control circuits 402, 411 is similar for both the "Pcontrol" 402 and the "Ncontrol" 411 circuits, with the N version being described in detail herein. The "Pcontrol" circuit 402 would comprise the complement of the N circuit. The "Ncontrol" circuit has a control input Ctrl and a reference Ref as well as the switch nodes Vlo and Sw. When a logical 1 is applied to the Ctrl input, the switch control circuit 411 is turned on, and with a logical 0, it is off. When the voltage across the switch terminals Sw and Vlo is larger than a given threshold voltage (VswTh), the output current is kept at a constant value, dependent on the reference value.

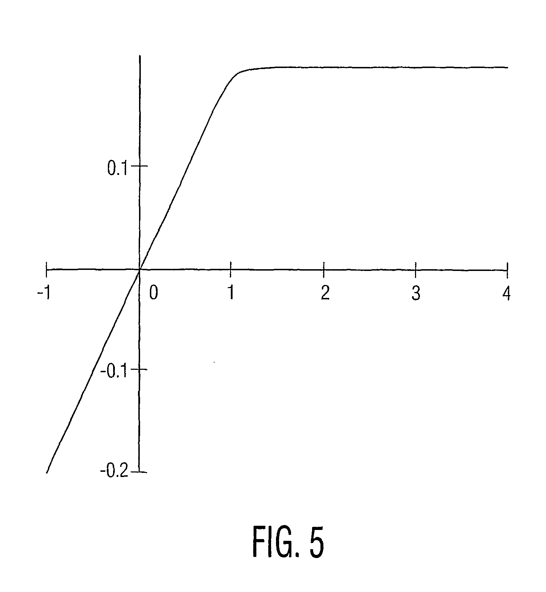

A graphical view of one example of the voltage-current relation (i.e., transfer characteristic) for the "on" switch is shown in FIG. 5 for a device that limits the output current to, for example, 200mA for switch voltages greater than 1V.

In the circuit of FIG. 4, the negative switch voltage is not possible because of the blocking diode D_1 319. At switch voltages less than 1V there is insufficient voltage to maintain the limit current and output current becomes a function of the switch voltage. When the switch voltage is 0V, the current is also 0. As noted, reference block RefGen 421 provides separate references for the two complementary switch control circuits 402, 411. In the example of FIG. 4, a current is used to provide the reference, but a voltage may also be used.

The HiLo input to the RefGen circuit 421 is used to select between two different reference current levels that are determined by the bus speed. During high speed operation, the current is fixed at the maximum level that develops the necessary slew rate for the bus through the switch control circuits 402, 411. With low speed operation, a period of low current is specified prior to the application of the maximum output level. This creates a longer slew, and thus reduces the EME in the low speed mode.

To restate, switch control circuits 402, 411 are provided in this example to limit current to a fixed value so that with a rising voltage on the floating bus, the amount of electromagnetic emissions is controlled. The amount of EME depends upon the sharpness of the switch on and switch off characteristics of the switch control circuit. FIG. 5 depicts one example of a desired transfer characteristic for the Ncontrol 411 circuit of FIG. 4. The slope shown in FIG. 5 determines the effective resistance of the switch. In the first phase, while the current and voltage are rising, EME is generated, while in the second phase the current remains substantially stable and is used to place charge onto the hold capacitor 204 and bus capacitor CBUS 213. The Vswitch in FIG. 5 represents the voltage difference between Vlo and Sw in Ncontrol circuit 411. As the voltage increases, the output current also increases until the Vsw equals approximately 1 volt, at which point the current becomes a constant 200 mA.

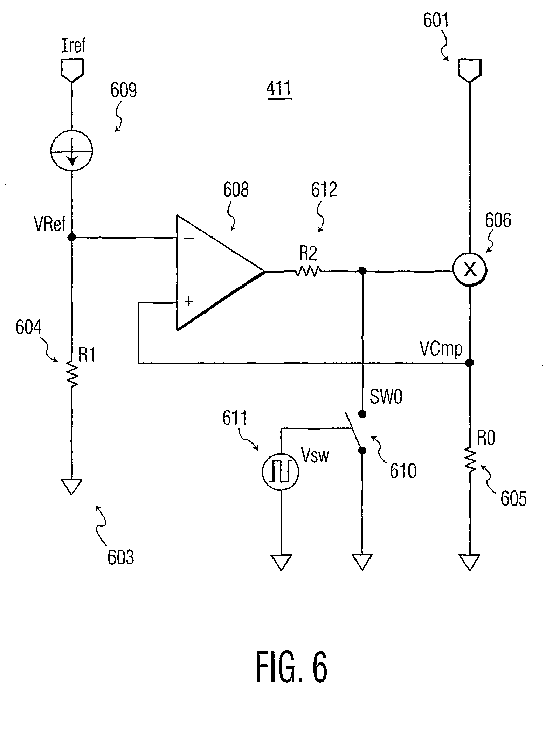

One embodiment of the N control circuit 411 is depicted in FIG. 6. In this embodiment, the function F ($V_{ctrl}$, $V_{Out}$), controls the output current lout 601 based on the comparison between the reference voltage VRef resulting from the current generated by the source 609 flowing through resistance R1 604 to ground 603. Reference voltage VRef comprises one input to an error amplifier 608, which has a second input of VCmp, created by the output current flowing through resistor R0 605. The ratio between the resistor values R1 604 and R0 605 allows scaling between the output and reference currents. The control operator 606 ensures that the output current remains essentially constant as the output voltage changes. As VOut approaches the same values as VCmp, the output regulation is unable to maintain the full output current and the current reduces. Switch 610 turns off the output current lout 601 when the switch is "on", under the control of signal Vsw 611. Resistor R2 612 allows the control VCtrl to be pulled to 0V to ensure that the output is fully disabled.

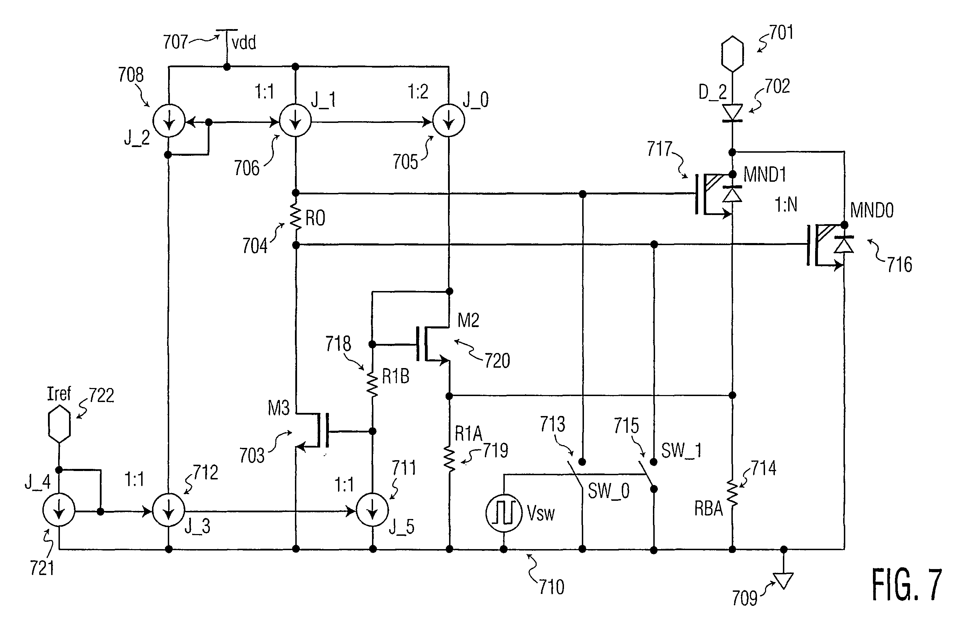

FIG. 7 depicts one transistor level implementation of an "Ncontrol" circuit such as described above in connection with FIG. 6.

With this design, the output is partitioned into two branches controlled by DMOS switches MND1 717 for BranchA and MDN0 716 for BranchB. Splitting the output current into two paths allows a small series-resistance RBA 714 in BranchA to create a sense voltage to be compared to the generated reference voltage, without introducing additional resistance into the main current path, BranchB.

The input node Iref 722 supplies the reference current $I_R$ that is folded through current mirrors J_4, J_3, J_5 721, 712, 711. The mirrors J_2, J_1, J_0 708, 706, 705 fold the reference current from the positive supply. Mirror J_0 705 doubles the output current to 2·$I_R$ and provides the correct biasing current $I_R$, for diode-connected NMOS transistor M2 720 and the remaining current (also $I_R$) is used to create an offset voltage across resistor RIB 718. An identical current $I_R$, biases the two NMOS transistors M3 703 and M2 720. Device M3 703 provides the gain of the circuit. The voltage Io·RBA is compared to the reference voltage obtained from $I_R$·RIB, the additional resistor RIA 719 corrects for the small error introduced by the addition of the reference current $I_R$ to the output current in BranchA. With the current $I_R$ in each path, the values of resistors R0, RIA and RIB are identical. The final value of the output current lout 701 through the blocking diode D_2 702 is obtained from the following:

$$Io = \frac{IR \cdot RIB}{RBA}$$

$$Iout = Io \cdot (N+1)$$

The offset at the source of transistor MND1, created by the current through RBA 714, is compensated at the gate drive nodes GateBA and GateBB by the resistor RO 704. When the circuit is operating in equilibrium the current through RO 704 is the same as the current in RIB 718, and both devices have the same voltage. The feedback loop around RO 704, MND1 717, RBA 714, M2 720, RIB 718 and M3 703 ensures that the voltage across RO 704 is the same as that across RBA 714. This condition remains true while the output voltage on the drain node remains sufficient to keep both DMOS switches MND1 717 and MND0 716 in saturation. In dynamic conditions, such as the pull-down of the output on node lout, and consequently on the drain, an amount of charge is lost to the gate of MND1 717 that creates an error in the voltage drop across R0 714. Similarly, an additional error is introduced by the current lost in charging the gate of MND0 716 that alters the bias condition of NMOS transistor M3 703. If the gate charging current is small relative to the bias current then the accuracy of the output current (N+1) · Io is sufficient for the purposes of this apparatus.

The switching of the output node is achieved by a control signal Vsw 710 that drives the gate switches SW_0 713 and SW_1 715. When the switches are turned on, the two gate nodes GateBA and GateBB are pulled down to ground, turning off both of the output DMOS transistors, MND1 717 and MND0 716, The current loss through the switches is limited by the current mirror J_1 706 to be $I_R$.

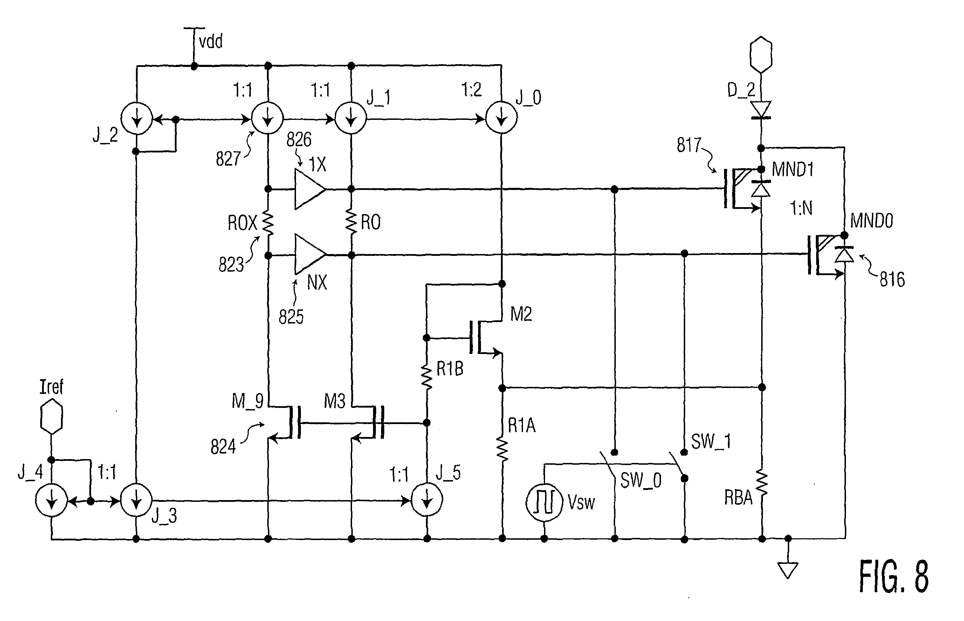

Errors introduced by the output lout 701 slewing mentioned in connection with FIG. 7, can be addressed by the circuit shown in FIG. 8. Two scaled class-B amplifiers 825, 826 are used to buffer a replication of the original amplifier output-stage. This is formed by the addition NMOS transistor N_9 824, resistor ROX 823 and current mirror J_6 827. The N:1 scaling at the output devices (MND1 817, MND0 816) requires a similar scaling in the gate current. This is achieved by scaling the buffers, with the buffer 825 driving GateBB being N times the strength of the buffer 826 that drives node GateBA. When the circuit turns on, the output lout begins to fall inducing current in the gate nodes due to the parasitic gate-capacitance on the output DMOS devices. When this happens, the buffers turn on and supply the additional current into the gate nodes. As equilibrium is achieved, the buffer stops supplying the additional current.

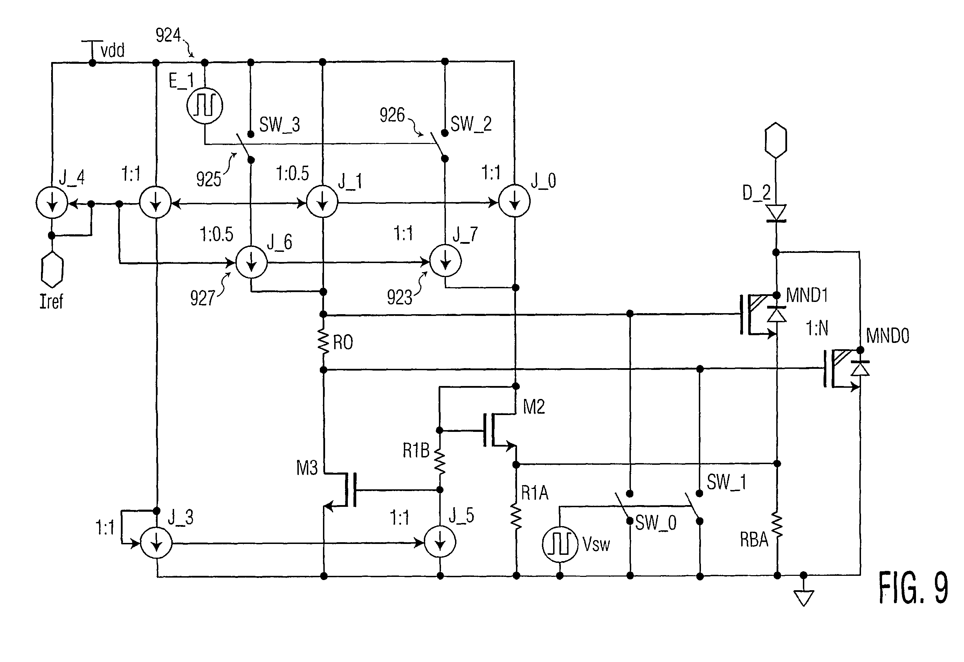

Returning to FIG. 7, when the output is disabled, the amplifier limits, with its gain transistor M3 703 driven into an off state. The switches 713, 715 sink the bias current $I_R$ that is also lost through the other stages. An additional variation of the circuit of FIG. 7 is depicted in FIG. 9. FIG. 9 provides an improvement in the switching time from control input to control output. To reduce the power losses in the circuit, a variation in the circuit splits the bias current sources into two parts for each branch. One part remains static, while the second part is switched. A separate control signal 924, two additional switches 925 and 926, with mirror devices 927 and 923 are combined to form the enhancements to the basic switch control circuit of FIG. 7. Keeping the circuit partly biased ensures that the startup of the circuit is improved. The overall current ratios are maintained so that when the circuit is on, the circuit behaves identically to that of FIG. 7.

The enhancements of FIG. 8 and FIG. 9 may also be combined into a single switch control circuit to obtain both the described improvements. In a full circuit implementation, the current mirrors may require cascoding to increase their output impedance. The use of cascode devices depends on the accuracy required for the output current Iout.

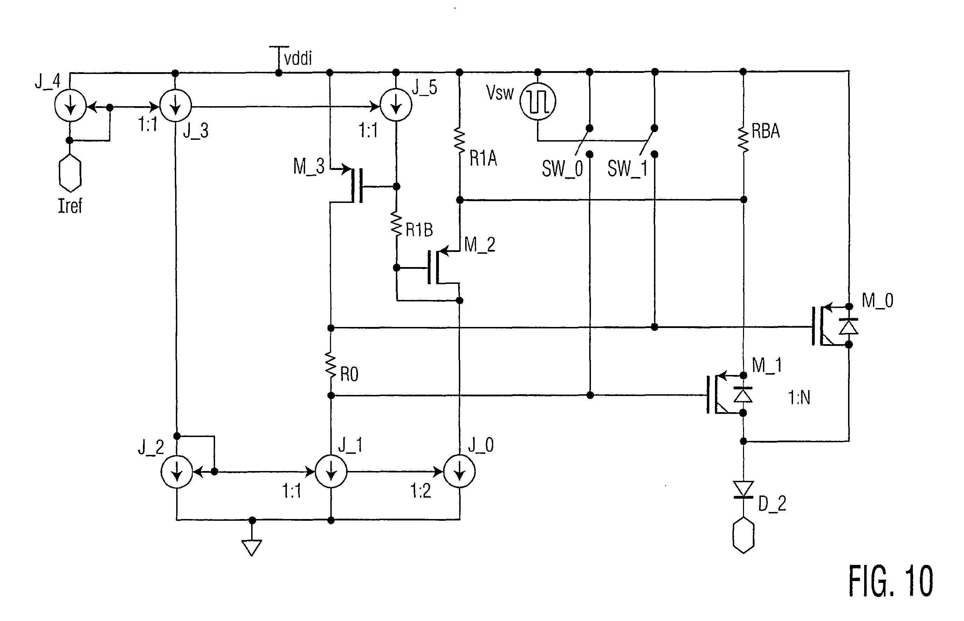

One embodiment of the complementary "Pcontrol" circuit is depicted in FIG. 10. FIG. 10 is essentially a PMOS/PDMOS version of the circuit of FIG. 7. Mirrors that were connected to ground in FIG. 7 now connect to the positive supply, and vice-versa for the remaining mirrors. P-type devices replace any N-type devices, and the operation of the circuit remains the same.

Although preferred embodiments have been depicted and described in detail herein, it will be apparent to those skilled in the relevant art that various modifications, additions, substitutions and the like can be made within the scope of the invention as defined in the following claims.

## Claims

1. A device comprising:

    - a floating bus (214, 215);
    - a power and data system (107, 301, 110,103) for driving the floating bus, and
    - a first switch control circuit (402) electrically connected to a first bus node (214) of the floating bus; and
    - a second switch control circuit (411) circuit electrically connected to a second bus node (215) of the floating bus, wherein the first and the second switch control circuits (402, 411) comprise complementary circuits, **characterized in that** the power and data system comprise a charge pump circuit that pre-charges the floating bus with a voltage, that is close to an original source-voltage; wherein the first and second switch control circuits (402, 411) are controlled to limit a current through the first and second switch control circuits (402, 411) to a fixed value with a rising voltage on the floating bus for facilitating a charging of the floating bus and for controlling electromagnetic emission from the device.

2. The device of claim 1, wherein the charge pump circuit comprises an integrated circuit employing at least one transistor and diode pair (301, 317; 110, 320).

3. The device of claim 1, wherein at least one switch control circuit (402, 411) is operable in at least a low speed mode and a high speed mode, with mode of the at least one switch control circuit being dependent upon a desired floating bus charging speed.

4. The device of claim 1, wherein the floating bus comprises a balanced bus system having a high side bus node (214) and a low side bus node (215), and wherein the at least one switch control circuit comprises a first switch control circuit (402) and a first diode (318) connected to the high side bus node and a second switch control circuit (411) and a second diode (319) connected to the low side bus node.

5. The device of claim 4, wherein the first switch control circuit (402) and the second switch control circuit (411) are driven by a reference circuit (421), the reference circuit generating a first reference signal for the first switch control circuit and a second reference signal for the second switch control circuit.

6. The device of claim 5, wherein when a voltage across a first terminal and a second terminal of the first switch control circuit is greater than a threshold value, output current from the first switch control circuit is constant at a value dependent on the first reference signal, and when voltage across a first terminal and a second terminal of the second switch control circuit is greater than the threshold value, output from the second switch control circuit is constant at a value dependent on the second reference signal.

7. The device of claim 1, wherein the at least one switch control circuit controls electromagnetic emission from the device by constraining the slew rate on the floating bus.

8. A method for operating a floating bus, **characterized by** the steps of:

    - tailoring a transfer characteristic of a first switch control circuit (402) to be electrically coupled to a high side bus node (214) of a floating bus by limiting a current through the first switch control circuit (402) to a fixed value when a voltage rises on the floating bus, and
    - tailoring a transfer characteristic of a second switch control circuit (411) to be electrically coupled to a low side bus node (215) of the floating bus by limiting a current through the second switch control circuit (411) to a fixed value when a voltage rises on the floating bus, wherein the first switch control circuit and the second switch control circuit comprise complementary control circuits for controlling charging of the floating bus by a power and data system (107, 301, 110, 103); and generating, when in use, a first reference signal (PRef) for the first switch control circuit and a second reference signal (NRef) for the second switch control circuit, wherein the first reference signal and the second reference signal are employed by the first switch control circuit and the second switch control circuit, respectively, for controlling electromagnetic emission from the floating bus by constraining a slew rate on the floating bus.

9. The method of claim 8, wherein the power and data system (107, 301, 110, 103) comprises a charge pump circuit, the charge pump circuit comprising an integrated circuit.

10. The method of claim 9, further comprising integrating the first switch control circuit (402) and the second switch control circuit (411) on the integrated circuit with the charge pump circuit.

11. The method of claim 8, wherein the first switch control circuit (402) and the second switch control circuit (411) are each operable in at least a low speed mode and a high speed mode, with mode of the first switch control circuit and second switch control circuit being determined by the first reference signal and the second reference signal, wherein the first reference signal and the second reference signal are generated by a reference circuit (421) electrically coupled to the first switch control circuit and the second switch control circuit, and wherein the method further comprises providing an input control signal to the reference circuit (421) for controlling a value of the first reference signal and a value of the second reference signal.

**Patentansprüche**

1. Vorrichtung, umfassend:

einen schwebenden Bus (214, 215);
ein Leistungs- und Datensystem (107, 301, 110, 103) zum Ansteuern des schwebenden Busses, und
eine erste Umschaltsteuerschaltung (402), die mit einem ersten Busknoten (214) des schwebenden Busses elektrisch verbunden ist; und
eine zweite Umschaltsteuerschaltung (411), die mit einem zweiten Busknoten (215) des schwebenden Busses elektrisch verbunden ist, wobei die ersten und zweiten Umschaltsteuerschaltungen (402, 411) komplementäre Schaltungen umfassen, **dadurch gekennzeichnet, dass** das Leistungs- und Datensystem eine Ladungspumpenschaltung umfasst, die den schwebenden Bus mit einer Spannung vorspannt, die nahe an einer ursprünglichen Quellenspannung ist; wobei die ersten und zweiten Umschaltsteuerschaltungen (402, 411) so gesteuert werden, dass sie einen Strom durch die ersten und zweiten Umschaltsteuerschaltungen (402, 411) auf einen festen Wert mit einer steigenden Spannung auf dem schwebenden Bus begrenzen, um ein Laden des schwebenden Busses zu erleichtern und um elektromagnetische Emissionen von der Vorrichtung zu kontrollieren.

2. Vorrichtung nach Anspruch 1, wobei die Ladungspumpenschaltung eine integrierte Schaltung umfasst, die wenigstens ein Transistor-und-Diode-Paar (301, 317, 110, 320) verwendet.

3. Vorrichtung nach Anspruch 1 , wobei wenigstens eine Umschaltsteuerschaltung (402, 411) in wenigstens einem Niedriggeschwindigkeitsmodus und einem Hochgeschwindigkeitsmodus betreibbar ist, wobei der Modus der wenigstens einen Umschaltsteuerschaltung von einer gewünschten Schwebebus-Ladegeschwindigkeit abhängig ist.

4. Vorrichtung nach Anspruch 1, wobei der schwebende Bus ein symmetrisches Bussystem mit einem Hochseite-Busknoten (214) und einem Niedrigseite-Busknoten (215) umfasst, und wobei die wenigstens eine Umschaltsteuerschaltung eine erste Umschaltsteuerschaltung (402) und eine erste Diode (318), die mit dem Hochseite-Busknoten verbunden ist, so wie eine zweite Umschaltsteuerschaltung (411) und eine zweite Diode (319), die mit dem Niedrigseite-Busknoten verbunden ist, umfasst.

5. Vorrichtung nach Anspruch 4, wobei die erste Umschaltsteuerschaltung (402) und die zweite Umschaltsteuerschaltung (411) von einer Referenzschaltung (421) angesteuert werden, und wobei die Referenzschaltung ein erstes Referenzsignal für die erste Umschaltsteuerschaltung und ein zweites Referenzsignal für die zweite Umschaltsteuerschaltung erzeugt.

6. Vorrichtung nach Anspruch 5, wobei dann, wenn eine Spannung über einem ersten Anschluss und einem zweiten Anschluss der ersten Umschaltsteuerschaltung größer ist als eine Schwellenspannung, der Ausgangsstrom von der ersten Umschaltsteuerschaltung einen konstanten Wert aufweist, der vom ersten Referenzsignal abhängig ist, und dann, wenn die Spannung über einem erstem Anschluss und einem zweiten Anschluss der zweiten Umschaltsteuerschaltung größer ist als der Schwellenwert, der Ausgang von der zweiten Umschaltsteuerschaltung einen konstanten Wert aufweist, der vom zweiten Referenzsignal abhängig ist.

7. Vorrichtung nach Anspruch 1 , wobei die wenigstens eine Umschaltsteuerschaltung elektromagnetische Emissionen von der Vorrichtung kontrolliert, indem sie die Anstiegsrate auf dem schwebenden Bus beschränkt.

8. Verfahren zum Betreiben eines schwebenden Busses, **gekennzeichnet durch** die Schritte:

Zuschneiden einer Übertragungscharakteristik einer ersten Umschaltsteuerschaltung (402), die mit einem Hochseite-Busknoten (214) eines schwebenden Busses elektrisch zu koppeln ist, **durch** Begrenzen eines Stroms durch die erste Umschaltsteuerschaltung (402) auf einen festen Wert, wenn eine Spannung auf dem schwebenden Bus ansteigt, und
Zuschneiden einer Übertragungscharakteristik einer zweiten Umschaltsteuerschaltung (411), die mit einem Niedrigseite-Busknoten (215) des schwebenden Busses elektrisch zu koppeln ist, **durch** Begrenzen eines Stroms durch die zweite Umschaltsteuerschaltung (411) auf einen festen Wert, wenn eine Spannung auf dem schwebenden Bus ansteigt, wobei die erste Umschaltsteuerschaltung und die zweite Umschaltsteuerschaltung komplementäre Steuerschaltungen umfassen zum Steuern des Ladens des schwebenden Busses mittels eines Leistungs- und Datensystems (107, 301, 110, 103); und Erzeugen, wenn in Gebrauch, eines ersten Referenzsignals (PRef) für die erste Umschaltsteuerschaltung und eines zweiten Referenzsignals (NRef) für die zweite Umschaltsteuerschaltung, wobei das erste Referenzsignal und das zweite Referenzsignal von der ersten Umschaltsteuerschaltung und der zweiten Umschaltsteuerschaltung entsprechend verwendet werden, um elektromagnetische Emissionen vom schwebenden Bus zu kontrollieren, indem eine Anstiegsrate am schwebenden Bus beschränkt wird.

9. Verfahren nach Anspruch 8, wobei das Leistungs- und Datensystem (107, 301, 110, 103) eine Ladungspumpenschaltung umfasst, und wobei die Ladungspumpenschaltung eine integrierte Schaltung umfasst.

10. Verfahren nach Anspruch 9, das ferner das Integrieren der ersten Umschaltsteuerschaltung (402) und der zweiten Umschaltsteuerschaltung (411) auf der integrierten Schaltung mit der Ladungspumpenschaltung umfasst.

11. Verfahren nach Anspruch 8, wobei die erste Umschaltsteuerschaltung (402) und die zweite Umschaltsteuerschaltung (411) jeweils in wenigstens einem Niedriggeschwindigkeitsmodus und einem Hochgeschwindigkeitsmodus betreibbar sind, wobei der Modus der ersten Umschaltsteuerschaltung und der zweiten Umschaltsteuerschaltung durch das erste Referenzsignal und das zweite Referenzsignal bestimmt wird, wobei das erste Referenzsignal und das zweite Referenzsignal von einer Referenzschaltung (421) erzeugt werden, die mit der ersten Umschaltsteuerschaltung und der zweiten Umschaltsteuerschaltung elektrisch gekoppelt ist, und wobei das Verfahren ferner das Liefern eines Eingangssteuersignals zu der Referenzschaltung (421) umfasst, um einen Wert des ersten Referenzsignals und einen Wert des zweiten Referenzsignals zu steuern.

## Revendications

1. Dispositif comprenant :

- un bus flottant (214, 215) ;
- un système d'alimentation et de données (107, 301, 110, 103) pour piloter le bus flottant, et
- un premier circuit de commande de commutation (402) raccordé électriquement à un premier noeud de bus (214) du bus flottant ; et
- un deuxième circuit de commande de commutation (411) raccordé électriquement à un deuxième noeud de bus (215) du bus flottant, dans lequel le premier et le deuxième circuit de commande de commutation (402, 411) comprennent des circuits complémentaires, **caractérisé par le fait que** le système d'alimentation et de données comporte un circuit de pompe de charge qui pré-charge le bus flottant avec une tension qui est proche d'une tension de source d'origine ; dans lequel le premier et le deuxième circuit de commande de commutation (402, 411) sont commandés de manière à limiter un courant à travers le premier et le deuxième circuit de commande de commutation (402, 411) à une valeur fixée avec une tension s'élevant sur le bus flottant pour faciliter une charge du bus flottant et pour contrôler les émissions électromagnétiques provenant du dispositif.

2. Dispositif selon la revendication 1, dans lequel le circuit de pompe de charge comprend un circuit intégré utilisant au moins une paire de transistor et diode (301, 317 ; 110, 320).

3. Dispositif selon la revendication 1, dans lequel au moins un circuit de commande de commutation (402, 411) peut fonctionner dans au moins un mode à basse vitesse et un mode à haute vitesse, le mode du circuit de commande de commutation au moins étant fonction d'une vitesse de charge souhaitée du bus flottant.

4. Dispositif selon la revendication 1, dans lequel le bus flottant comporte un système de bus équilibré ayant un noeud de bus du côté élevé (214) et un noeud de bus du côté bas (215), et dans lequel le circuit de commande de commutation au moins comporte un premier circuit de commande de commutation (402) et une première diode (318) raccordée au noeud de bus du côté élevé et un deuxième circuit de commande de commutation (411) et une première diode (319) raccordée au noeud de bus du côté bas.

5. Dispositif selon la revendication 4, dans lequel le premier circuit de commande de commutation (402) et le deuxième circuit de commande de commutation (411) sont pilotés par un circuit de référence (421), le circuit de référence générant un premier signal de référence pour le premier circuit de commande de commutation et un deuxième signal de référence pour le deuxième circuit de commande de commutation.

6. Dispositif selon la revendication 5, dans lequel lorsqu'une tension entre une première borne et une deuxième borne du premier circuit de commande de commutation est supérieure à une valeur de seuil, le courant de sortie du premier circuit de commande de commutation est constant à une valeur dépendant du premier signal de référence, et lorsqu'une tension entre une première borne et une deuxième borne du deuxième circuit de commande de commutation est supérieure à la valeur de seuil, le courant de sortie du deuxième circuit de commande de commutation est constant à une valeur dépendant du deuxième signal de référence.

7. Dispositif selon la revendication 1, dans lequel le circuit de commande de commutation au moins contrôle les émissions électromagnétiques provenant du dispositif en contraignant la vitesse de montée sur le bus flottant.

8. Procédé d'exploitation d'un bus flottant, **caractérisé par** les étapes suivantes :

- mise au point d'une caractéristique de transfert d'un premier circuit de commande de commutation (402) destiné à être raccordé électriquement à un noeud de bus côté haut (214) d'un bus flottant en limitant un courant à travers le premier circuit de commande de commutation (402) à une valeur fixée lorsqu'une tension s'élève sur le bus flottant, et
- mise au point d'une caractéristique de transfert d'un deuxième circuit de commande de commutation (411) destiné à être raccordé électriquement à un noeud de bus côté bas (215) du bus flottant en limitant un courant à travers le deuxième circuit de commande de commutation (411) à une valeur fixée lorsqu'une tension s'élève sur le bus flottant, dans lequel le premier circuit de commande de commutation et le deuxième circuit de commande de commutation comportent des circuits de commande complémentaires pour commander la charge du bus flottant par un système d'alimentation et de données (107, 301, 110, 103) ; et génération, pendant l'utilisation, d'un premier signal de référence (PRef) pour le premier circuit de commande de commutation et d'un deuxième signal de référence (NRef) pour le deuxième circuit de commande de commutation, dans lequel le premier signal de référence et le deuxième signal de référence sont utilisés respectivement par le premier circuit de commande de commutation et le deuxième circuit de commande de commutation, pour contrôler les émissions électromagnétiques provenant du bus flottant en contraignant un temps de montée sur le bus flottant.

9. Procédé selon la revendication 8, dans lequel le système d'alimentation et de données (107, 301, 110, 103) comprend un circuit de pompe de charge, le circuit de pompe de charge comprenant un circuit intégré.

10. Procédé selon la revendication 9, comprenant en outre l'intégration du premier circuit de commande de commutation (402) et du deuxième circuit de commande de commutation (411) dans le circuit intégré avec le circuit de pompe de charge.

11. Procédé selon la revendication 8, dans lequel le premier circuit de commande de commutation (402) et le deuxième circuit de commande de commutation (411) peuvent fonctionner chacun dans au moins un mode à basse vitesse et un mode à haute vitesse, le mode du premier circuit de commande de commutation et du deuxième circuit de commande de commutation étant déterminé par le premier signal de référence et le deuxième signal de référence, dans lequel le premier signal de référence et le deuxième signal de référence sont générés par un circuit de référence (421) raccordé électriquement au premier circuit de commande de commutation et au deuxième circuit de commande de commutation, et dans lequel le procédé comprend en outre la fourniture au circuit de référence (421) d'un signal de commande en entrée pour commander une valeur du premier signal de référence et une valeur du deuxième signal de référence.

FIG. 1

FIG. 2

EP 1 568 135 B1

FIG. 3

EP 1 568 135 B1

FIG. 4

EP 1 568 135 B1

FIG. 5

FIG. 6

FIG. 7

FIG. 8

FIG. 9

EP 1 568 135 B1

FIG. 10

EP 1 568 135 B1

**EP 1 568 135 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4807104 A
- US 6154061 A
- EP 1065600 A2